# EUROPEAN PATENT APPLICATION

(11) **EP 3 820 261 A1**
(43) Date of publication of application: **12.05.2021**
(21) Application number: 18922095.7
(22) Date of filing: 13.09.2018
(51) Int. Cl.: H05K 7/20, H05B 3/40

(54) **TUBULAR ELECTRIC HEATING ELEMENT ASSEMBLY FOR HEATING EQUIPMENT**

(30) Priority: 06.07.2018 RU 2018124792
(71) Applicant: Joint Stock Company "Experimental And Design Organisation "Gidropress" Awarded The Order of The Red Banner of Labour And Czsr Order of Labour, Podolsk, Moskovskaya obl. 142103 (RU)
(72) Inventor: GAVRILIN, Viktor Alekseevich, Moskovskaya obl. g. Podolsk 142100 (RU)
(74) Representative: Friese Goeden Patentanwälte PartGmbB
(86) International application number: PCT/RU2018/000605
(87) International publication number: WO 2020/009603

(57) **Abstract**

THE DEVICE RELATES TO ELECTRIC HEATERS, IN PARTICULAR TO ELECTRIC HEATERS IN NUCLEAR REACTOR SAFETY SYSTEMS.

THE OBJECT OF THE INVENTION IS TO IMPROVE THE RELIABILITY OF THE TEN UNIT IN OPERATION AT A NUCLEAR POWER PLANT.

THE TECHNICAL RESULT OF THE PRESENT INVENTION IS TO PROVIDE A DEVICE THAT REDUCES THE THERMAL INFLUENCE FROM THE HEATED ELEMENTS OF THE EQUIPMENT ON THE FINDINGS OF THE TUBULAR ELECTRIC HEATER AND, AS A CONSEQUENCE, LOWERING THE TEMPERATURE OF THE HOST ELECTRICAL CONNECTION.

THE TECHNICAL RESULT IS ACHIEVED IN THAT IN THE TUBULAR UNIT HEATERS EQUIPMENT INCLUDING FLANGE (COVER) WITH THREADED HOLES AND BUSHINGS, WHICH ARE RIGIDLY SEALED TUBULAR HEATERS WITH THE CONCLUSIONS AND FINDINGS OF THE TUBULAR ELECTRIC HEATER MADE OF ELECTRIC PORTABLE NODE CONNECTIONS, AND PROTECTIVE JACKET, WHICH IS MOUNTED ON THE FLANGE FROM THE INSIGHTS OF THE TUBULAR HEATER, OFFERED ON THE MODULE FLANGE TUBULAR ELECTRIC HEATERS, FROM THE INSIGHTS OF TUBULAR ELECTRIC HEATERS, SET THE CYLINDRICAL SHELL, ON THE UPPER HALF OF WHICH TO PERFORM A THROUGH PERFORATION, ON THE INNER SURFACE OF THE CYLINDRICAL SHELL RIGIDLY FIX AT LEAST TWO HEAT SHIELDS WITH HOLES FOR TUBULAR ELECTRIC HEATERS, AND THE DIAMETER OF THE HOLES IN THE HEAT SHIELDS SHOULD EXCEED THE OUTER DIAMETER OF THE SLEEVE.

ALTERNATIVELY, THE SIZE OF THE SHELL IS EQUAL TO OR LESS THAN THE THICKNESS OF THE THERMAL INSULATION OF THE EQUIPMENT. ALTERNATIVELY, THE PROTECTIVE CASING IS INSTALLED IN THE AREA OF THE TERMINALS OF TUBULAR ELECTRIC HEATERS, WITH WHICH IT IS TIGHTLY CONNECTED BY MASSIVE METAL BUSHINGS.

ALTERNATIVELY, THERMAL INSULATION IS INSTALLED IN THE SPACE BETWEEN THE HEAT SHIELDS.

## Description

THE DEVICE RELATES TO ELECTRIC HEATERS, IN PARTICULAR TO ELECTRIC HEATERS IN THE SAFETY SYSTEMS OF NUCLEAR REACTORS OF NUCLEAR POWER PLANTS. KNOWN TUBULAR UNIT INCLUDING A FLANGE (COVER) WITH THREADED HOLES AND SPIGOT, WHICH IS TIGHTLY SEALED TUBE HEATER (THE HEATER) WITH THE CONCLUSIONS AND FINDINGS OF THE TUBULAR ELECTRIC HEATER IS MADE OF A COLLAPSIBLE NODE (THREADED) ELECTRICAL CONNECTION AND A HERMETIC PROTECTIVE CASING, WHICH IS MOUNTED ON THE BLOCK FLANGE TUBULAR ELECTRIC HEATERS FROM THE INSIGHTS OF THE TUBULAR ELECTRIC HEATER (TU 16-681.097-85 "BLOCK TUBULAR TANB- 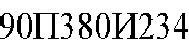 "). THE MAIN DISADVANTAGE OF THIS DESIGN IS THE POSSIBILITY OF OVERHEATING OF THE HEATING ELEMENTS IN A SEALED CASING IN THE ABSENCE OF FORCED AIR CIRCULATION. IN ADDITION, THE DISADVANTAGE OF THIS DESIGN IS THE INACCESSIBILITY OF THE TERMINALS DURING ELECTRICAL INSTALLATION.

THE CLOSEST IN TECHNICAL ESSENCE IS THE DEVICE "BLOCK TUBULAR" (RF PATENT FOR USEFUL MODEL NO. 50639, IPC F24H 3/08 (2006.01), G21C 1/00 (2006.01), PRIORITY, 25.02.2005), IN WHICH THE PROTECTIVE COVER FROM THE CONCLUSIONS OF THE HEATING ELEMENT, MADE OF A PIPE, RIGIDLY CONNECTED WITH THE PLATE WITH HOLES FOR TERMINALS OF ELECTRIC HEATING ELEMENTS, WHICH IN TURN IS SECURED TO THE FLANGE BY MEANS OF FASTENING ELEMENTS SCREWED INTO THE THREADED HOLES OF THE ABOVE FLANGES. THE TECHNICAL DECISION WAS MADE FOR THE PROTOTYPE.

THE DISADVANTAGE OF THE KNOWN DEVICE, TAKEN AS A PROTOTYPE, IS THE POSSIBILITY OF OVERHEATING THE TERMINALS OF THE HEATING ELEMENT DURING OPERATION DUE TO HEAT EMISSIONS FROM THE SURFACE OF THE HEATED EQUIPMENT.

THIS DISADVANTAGE IS ELIMINATED BY THE CLAIMED DEVICE.

THE OBJECT OF THE INVENTION IS TO IMPROVE THE RELIABILITY OF THE TEN UNIT IN OPERATION AT A NUCLEAR POWER PLANT.

THE TECHNICAL RESULT OF THE PRESENT INVENTION IS TO PROVIDE A DEVICE THAT REDUCES THE THERMAL INFLUENCE FROM THE HEATED ELEMENTS OF THE EQUIPMENT ON THE FINDINGS OF THE TUBULAR ELECTRIC HEATER AND, AS A CONSEQUENCE, LOWERING THE TEMPERATURE OF THE HOST ELECTRICAL CONNECTION.

THE TECHNICAL RESULT IS ACHIEVED IN THAT IN THE TUBULAR UNIT HEATERS EQUIPMENT INCLUDING FLANGE (COVER) WITH THREADED HOLES AND BUSHINGS, WHICH ARE RIGIDLY SEALED TUBULAR HEATERS WITH THE CONCLUSIONS AND FINDINGS OF THE TUBULAR ELECTRIC HEATER MADE OF ELECTRIC PORTABLE NODE CONNECTIONS, AND PROTECTIVE JACKET, WHICH IS MOUNTED ON THE FLANGE FROM THE INSIGHTS OF THE TUBULAR HEATER, OFFERED ON THE MODULE FLANGE TUBULAR ELECTRIC HEATERS, FROM THE INSIGHTS OF TUBULAR ELECTRIC HEATERS, SET THE CYLINDRICAL SHELL, ON THE UPPER HALF OF WHICH TO PERFORM A THROUGH PERFORATION, ON THE INNER SURFACE OF THE CYLINDRICAL SHELL RIGIDLY FIX AT LEAST TWO HEAT SHIELDS WITH HOLES FOR TUBULAR ELECTRIC HEATERS, AND THE DIAMETER OF THE HOLES IN THE HEAT SHIELDS SHOULD EXCEED THE OUTER DIAMETER OF THE SLEEVE.

ALTERNATIVELY, THE SIZE OF THE SHELL IS EQUAL TO OR LESS THAN THE THICKNESS OF THE THERMAL INSULATION OF THE EQUIPMENT. ALTERNATIVELY, THE PROTECTIVE CASING IS INSTALLED IN THE AREA OF THE TERMINALS OF TUBULAR ELECTRIC HEATERS, WITH WHICH IT IS TIGHTLY CONNECTED BY MASSIVE METAL BUSHINGS.

ALTERNATIVELY, THERMAL INSULATION IS INSTALLED IN THE SPACE BETWEEN THE HEAT SHIELDS.

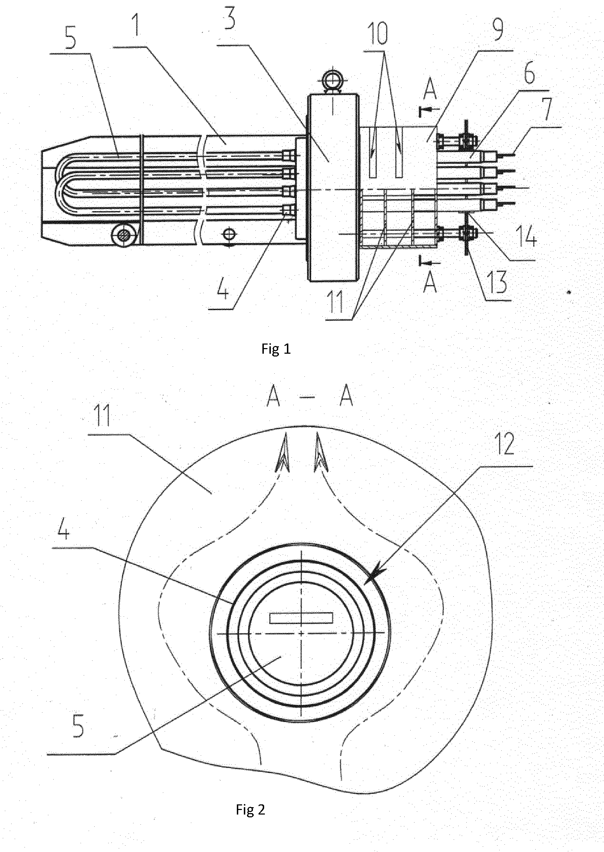

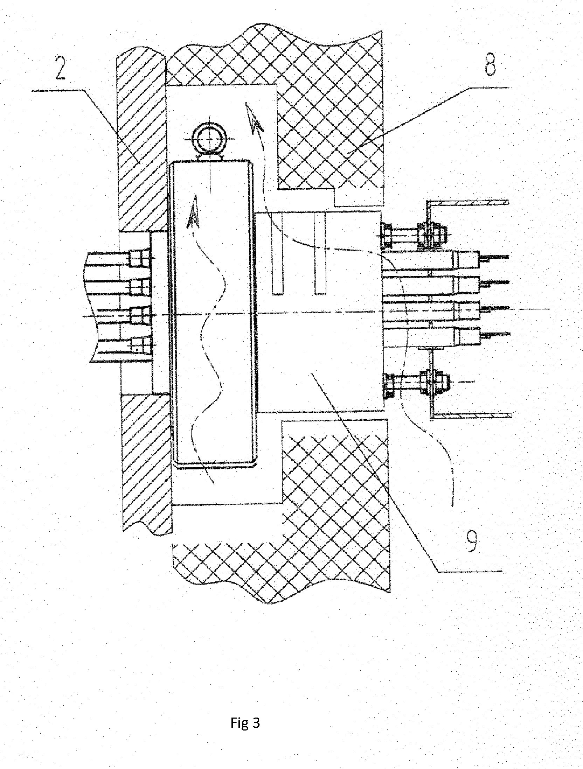

THE ESSENCE OF THE INVENTION IS EXPLAINED BY DRAWINGS. IN FIG.1 SHOWS A GENERAL VIEW OF THE BLOCK TUBULAR ELECTRIC HEATERS. IN FIG.2 SHOWS THE SCHEME OF NATURAL CIRCULATION OF HOT AIR AROUND THE TUBULAR ELECTRIC HEATER. IN FIG.3 SHOWS THE DIRECTION OF MOVEMENT OF THE "COLD" AIR COOLING THE CYLINDER AND THE HOT AIR AROUND THE CYLINDRICAL SHELL.

BLOCK OF TUBULAR HEATERS 1 EQUIPMENT 2 INCLUDES A FLANGE (COVER) 3 WITH THREADED HOLES AND A BUSHING 4 IN WHICH IS TIGHTLY SEALED TUBULAR ELECTRIC HEATER 5 AND A PIN 6, AND PIN 6 OF THE TUBULAR ELECTRIC HEATER 5 MADE OF A HOST PORTABLE ELECTRIC CONNECTION 7. THERMAL INSULATION 8 IS INSTALLED ON EQUIPMENT 2 AND FLANGE 3. ON THE FLANGE 3 ON THE SIDE OF THE TERMINALS 6 OF THE TUBULAR ELECTRIC HEATER 5, A CYLINDRICAL SHELL 9 IS INSTALLED. ON THE UPPER HALF OF THE CYLINDRICAL SHELL 9, A THROUGH PERFORATION 10 IS MADE. ON THE INNER SURFACE OF THE CYLINDRICAL SHELL 9, SEVERAL, AT LEAST TWO, HEAT SHIELDS 11 WITH HOLES 12 FOR TUBULAR ELECTRIC HEATERS 5 ARE RIGIDLY FIXED, AND THE DIAMETER OF THE HOLES 12 EXCEEDS THE OUTER DIAMETER OF THE SLEEVE 4. ALTERNATIVELY, THE SIZE OF THE CYLINDRICAL SHELL 9 IS EQUAL TO OR LESS THAN THE THICKNESS OF THE THERMAL INSULATION 8 OF THE EQUIPMENT 2. ALTERNATIVELY, THE PROTECTIVE CASING 13 IS MOUNTED ON THE TERMINALS 6 IN THE AREA OF THE ELECTRICAL CONNECTION UNIT 7, AND THE PROTECTIVE CASING 13 IS TIGHTLY CONNECTED TO THE BUSHINGS 4 OF THE TUBULAR ELECTRIC HEATERS 5 BY MASSIVE METAL BUSHINGS 14.

OPERATION OF THE DEVICE IS CARRIED OUT AS FOLLOWS. TUBULAR ELECTRIC HEATERS UNIT 1 EQUIPMENT 2 INCLUDES FLANGE (COVER) 3 THREADED

HOLES AND A BUSHING 4 IN WHICH IS TIGHTLY SEALED TUBULAR ELECTRIC HEATER 5 AND A PIN 6, AND PIN 6 OF THE TUBULAR ELECTRIC HEATER 5 IS MADE OF A COLLAPSIBLE NODE THE ELECTRICAL CONNECTION 7 IS USED IN SAFETY SYSTEMS OF NUCLEAR REACTORS. ON THE EQUIPMENT 2 AND THE FLANGE 3 SHAPED BY THERMAL INSULATION 8. ON THE FLANGE 3, ON THE SIDE OF THE TERMINALS 6 OF THE TUBULAR ELECTRIC HEATER 5, A CYLINDRICAL SHELL 9 IS INSTALLED, WHICH ORGANIZES THE MOVEMENT OF HOT AIR ALONG THE WALL OF THE EQUIPMENT 2 AND CLOSES THE TERMINALS 6 OF THE TUBULAR ELECTRIC HEATERS 5 FROM THE INFLUENCE OF HOT AIR RISING ALONG THE WALL OF THE EQUIPMENT 2. ON THE UPPER SURFACE OF THE CYLINDRICAL SHELL 9, A THROUGH PERFORATION 10 IS MADE, WHICH ENSURES THE REMOVAL OF EXCESS HEAT FROM THE TERMINALS 6 OF THE TUBULAR ELECTRIC HEATERS 5. ON THE INNER SURFACE OF THE CYLINDRICAL SHELL 9, SEVERAL, AT LEAST TWO, HEAT SHIELDS 11 WITH HOLES 12 FOR TUBULAR ELECTRIC HEATERS 5 ARE RIGIDLY FIXED TO EXCLUDE RADIANT HEAT EXCHANGE BETWEEN THE HOT FLANGE 3 AND THE TERMINALS 6 OF THE TUBULAR ELECTRIC HEATERS 5. THE DIAMETER OF THE HOLES 12 EXCEEDS THE OUTER DIAMETER OF THE SLEEVE 4 TO ALLOW THE PASSAGE OF COOLING "COLD" AIR ALONG THE PINS 6. ALTERNATIVELY, THE SIZE OF THE CYLINDRICAL SHELL 9 IS EQUAL TO OR LESS THAN THE THICKNESS OF THE THERMAL INSULATION 8 OF THE EQUIPMENT 2. ALTERNATIVELY, THE PROTECTIVE COVER 13 MOUNTED ON THE PIN 6 IN THE AREA OF THE NODE, THE ELECTRICAL CONNECTION 7, AND THE PROTECTIVE COVER 13 IS TIGHTLY CONNECTED TO THE BUSHING 4 TUBULAR 5 SOLID METAL BUSHINGS 14 THAT ALIGN THE TEMPERATURE OF THE SEALANT IN THE NODE SEALING OF TUBULAR ELECTRIC HEATERS 5, AND THE PROTECTIVE CASING 13 SERVES AS A RADIATOR TO REMOVE EXCESS HEAT FROM THE FINDINGS 6 OF THE TUBULAR 5.

THUS, THE USE OF THE CLAIMED TECHNICAL SOLUTION IN COMPARISON WITH KNOWN DEVICES PROVIDES PROTECTION OF THE TERMINALS OF TUBULAR ELECTRIC HEATERS FROM THE INFLUENCE OF HEATED EQUIPMENT ELEMENTS, SUCTION OF "COLD" AIR ALONG THE TERMINALS, REMOVAL OF EXCESS HEAT FROM THE TERMINALS OF TUBULAR ELECTRIC HEATERS, REDUCTION AND EQUALIZATION OF THE TEMPERATURE OF THE ELECTRICAL CONNECTIONS, INCREASES THE RELIABILITY OF THE TUBULAR ELECTRIC HEATERS UNIT. 5.

## Claims

1. BLOCK OF TUBULAR HEATERS THAT INCLUDES A FLANGE (COVER) WITH THREADED HOLES AND BUSHINGS, WHICH ARE RIGIDLY SEALED TUBULAR HEATERS WITH CONCLUSIONS AND A PROTECTIVE CASING, WHICH IS MOUNTED ON THE FLANGE FROM THE INSIGHTS OF THE TUBULAR ELECTRIC HEATER, **CHARACTERIZED IN THAT** THE MODULE FLANGE TUBULAR ELECTRIC HEATERS FROM THE INSIGHTS OF TUBULAR ELECTRIC HEATERS MOUNTED CYLINDRICAL SHELL, UPPER HALF OF WHICH IS A THROUGH PERFORATION ON THE INNER SURFACE OF THE CYLINDRICAL SHELL RIGIDLY FIXED SEVERAL, AT LEAST TWO, HEAT SHIELDS WITH HOLES FOR TUBULAR ELECTRIC HEATERS, WHEREIN THE DIAMETER OF THE HOLES EXCEEDS THE OUTER DIAMETER OF THE FLANGE SLEEVE OF THE TUBULAR ELECTRIC HEATERS UNIT.

2. BLOCK TUBULAR ELECTRIC HEATERS ACCORDING TO CLAIM 1, **CHARACTERIZED IN THAT** THE SIZE OF THE CYLINDRICAL SHELL IS EQUAL TO OR LESS THAN THE THICKNESS OF THE THERMAL INSULATION OF THE EQUIPMENT.

3. THE BLOCK OF TUBULAR ELECTRIC HEATERS ACCORDING TO CLAIM 1, **CHARACTERIZED IN THAT** THE PROTECTIVE CASING IS INSTALLED IN THE AREA OF THE TERMINALS OF TUBULAR ELECTRIC HEATERS, WITH WHICH IT IS TIGHTLY CONNECTED BY MASSIVE METAL BUSHINGS.

4. BLOCK TUBULAR ELECTRIC HEATERS ACCORDING TO CLAIM 1, **CHARACTERIZED IN THAT** THE SPACE BETWEEN THE HEAT SHIELDS INSTALLED THERMAL INSULATION.
